(19) Europäisches Patentamt
European Patent Office
Office européen des brevets

(11) **EP 4 290 711 B1**

(12) **EUROPEAN PATENT SPECIFICATION**

(45) Date of publication and mention
of the grant of the patent:
**18.03.2026 Bulletin 2026/12**

(21) Application number: **21948959.8**

(22) Date of filing: **10.08.2021**

(51) International Patent Classification (IPC):
*H01S 5/42* (2006.01)    *H01S 5/042* (2006.01)
*H01S 5/183* (2006.01)

(52) Cooperative Patent Classification (CPC):
**H01S 5/423; H01S 5/04256; H01S 5/04257;
H01S 5/18313; H01S 5/18394;** H01S 5/04254;
H01S 2301/176

(86) International application number:
**PCT/CN2021/111723**

(87) International publication number:
**WO 2023/279469 (12.01.2023 Gazette 2023/02)**

(54) **VERTICAL-CAVITY SURFACE-EMITTING LASER**

OBERFLÄCHENEMITTIERENDER LASER MIT VERTIKALEM RESONATOR

LASER À CAVITÉ VERTICALE ET À ÉMISSION PAR LA SURFACE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **09.07.2021 CN 202110777105**

(43) Date of publication of application:
**13.12.2023 Bulletin 2023/50**

(73) Proprietor: **Vertilite Co., Ltd.
Changzhou, Jiangsu 213000 (CN)**

(72) Inventors:
• **WENG, Weicheng
Changzhou, Jiangsu 213000 (CN)**
• **ZHANG, Cheng
Changzhou, Jiangsu 213000 (CN)**
• **LIU, Song
Changzhou, Jiangsu 213000 (CN)**
• **LIANG, Dong
Changzhou, Jiangsu 213000 (CN)**

(74) Representative: **HGF
HGF Limited
4th Floor, 1 City Square
Leeds LS1 2ES (GB)**

(56) References cited:
CN-A- 110 323 669    CN-A- 110 858 702
CN-A- 112 335 143    CN-A- 112 970 156
JP-A- 2007 073 585    US-A1- 2018 366 907
US-A1- 2019 067 908    US-A1- 2019 273 360
US-A1- 2020 144 792    US-A1- 2020 321 754
US-A1- 2021 104 867    US-A1- 2021 167 579

**Description**

TECHNICAL FIELD

The present application relates to the field of semiconductor technologies, for example, a vertical cavity surface emitting laser.

BACKGROUND

A vertical cavity surface emitting laser (VCSEL) is developed on the basis of the semiconductor material of gallium arsenide. Due to its advantages of small volume, low threshold current, high modulation frequency and easy fiber coupling, the VCSEL may be not only applied in optical communication, optical interconnection, optical information processing and other fields, but also applied in the mobile phone, the unmanned vehicle light detection and ranging (Lidar) and other electronic consumption fields as a light source of structured light technology in 3-Dimension (3D) recognition.

To achieve a VCSEL with a small dimension, it is necessary to keep reducing the spacing between the adjacent emitters in the VCSEL. However, the spacing between the adjacent emitters may not be further reduced due to the structural arrangement of the VCSEL.

Further relevant technologies are also known from US 2021/104867 A1 which relates to a VCSEL array with small pulse delay and US 2019/076908 A1 which relates to a method and an apparatus for forming materials with low ductility.

SUMMARY

The invention is set out in the appended set of claims.

BRIEF DESCRIPTION OF DRAWINGS

FIG. 1 is a top diagram of a VCSEL according to an embodiment of the present application;
FIG. 2 is a sectional diagram of the VCSEL in FIG. 1 taken along the A1-A2 direction;
FIG. 3 is a sectional diagram of the VCSEL in FIG. 1 taken along the B1-B2 direction;
FIG. 4 is another sectional diagram of the VCSEL in FIG. 1 taken along the A1-A2 direction;
FIG. 5 is another sectional diagram of the VCSEL in FIG. 1 taken along the B1-B2 direction;
FIG. 6 is another sectional diagram of the VCSEL in FIG. 1 taken along the A1-A2 direction;
FIG. 7 is another sectional diagram of the VCSEL in FIG. 1 taken along the B1-B2 direction;
FIG. 8 is another top diagram of a VCSEL according to an embodiment of the present application;
FIG. 9 is another top diagram of a VCSEL according to an embodiment of the present application;
FIG. 10 is a sectional diagram of the VCSEL in FIG. 9 taken along the A1-A2 direction;
FIG. 11 is a sectional diagram of the VCSEL in FIG. 9 taken along the B1-B2 direction;
FIG. 12 is another top diagram of a VCSEL according to an embodiment of the present application;
FIG. 13 is a sectional diagram of the VCSEL in FIG. 12 taken along the A1-A2 direction;
FIG. 14 is a sectional diagram of the VCSEL in FIG. 12 taken along the B1-B2 direction;
FIG. 15 is another top diagram of a VCSEL according to an embodiment of the present application;
FIG. 16 is another top diagram of a VCSEL according to an embodiment of the present application;
FIG. 17 is a sectional diagram of the VCSEL in FIG. 16 taken along the A1-A2 direction; and
FIG. 18 is a sectional diagram of the VCSEL in FIG. 16 taken along the B1-B2 direction.

DETAILED DESCRIPTION

The present application is described below in conjunction with drawings and embodiments.

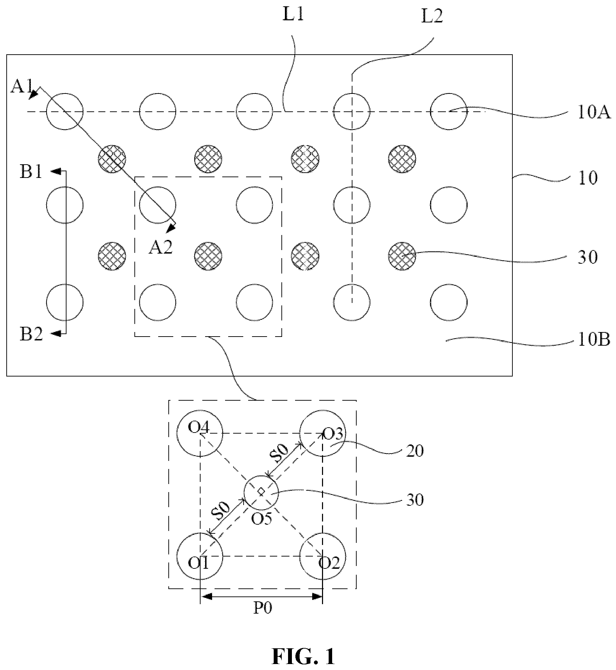

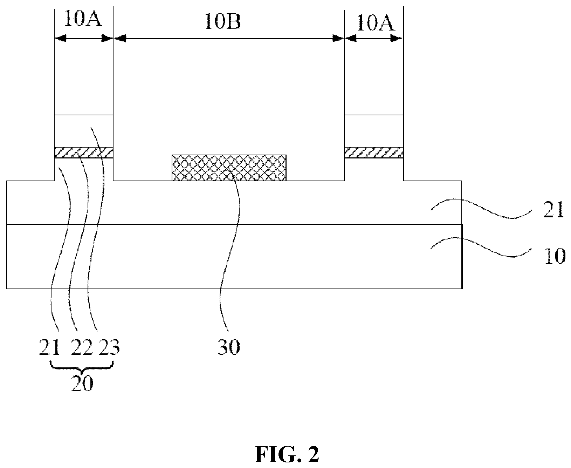

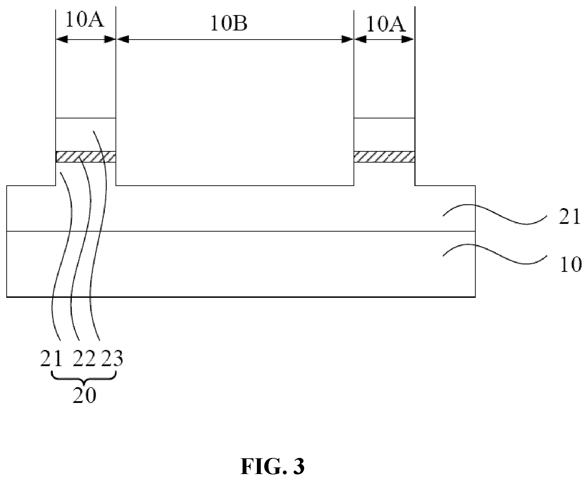

Embodiments of the present application provide a VCSEL. FIG. 1 is a top diagram of a VCSEL according to an embodiment of the present application. FIG. 2 is a sectional diagram of the VCSEL in FIG. 1 taken along the A1-A2 direction. FIG. 3 is a sectional diagram of the VCSEL in FIG. 1 taken along the B1-B2 direction. Referring to FIGS. 1 to 3, the VCSEL includes a substrate 10, emitters 20 arranged in an m×n array, and a first ohmic metal layer 30. A surface of the substrate 10 includes light-emitting regions 10A arranged in an array of m rows and n columns and a non-light-emitting region 10B surrounding the light-emitting regions 10A, where m is an integer greater than or equal to 1, n is an integer greater than or equal to 1, and a product of m and n is greater than or equal to 2. Each of the emitters 20 includes a first DBR 21 disposed on the surface of the substrate 10, an active layer 22 disposed on a side of the first DBR 21 facing away from the substrate 10, and a second DBR 23 disposed on a side of the active layer 22 facing away from the substrate 10, where at least part of the first DBR 21 is disposed in a respective light-emitting region 10A, and the active layer 22 and the second DBR 23 are disposed in the respective light-emitting region 10A. The first ohmic metal layer 30 is disposed on a surface of the first DBR 21 facing away from the substrate 10 and disposed in the non-light-emitting region 10B, where a projection of the first ohmic metal layer 30 on the substrate 10 does not overlap with a projection of a first connecting line L1 on the substrate 10, and the projection of the first ohmic metal layer 30 on the substrate 10 does not overlap with a projection of a second connecting line L2 on the substrate 10, where the first connecting line L1 is a straight line connecting centers of emitters 20 in a same row, and the second connecting line L2 is a straight line connecting centers of emitters 20 in a same column. The emitter 20 further includes a second ohmic contact layer (not shown in the figure) disposed on the second DBR 23.

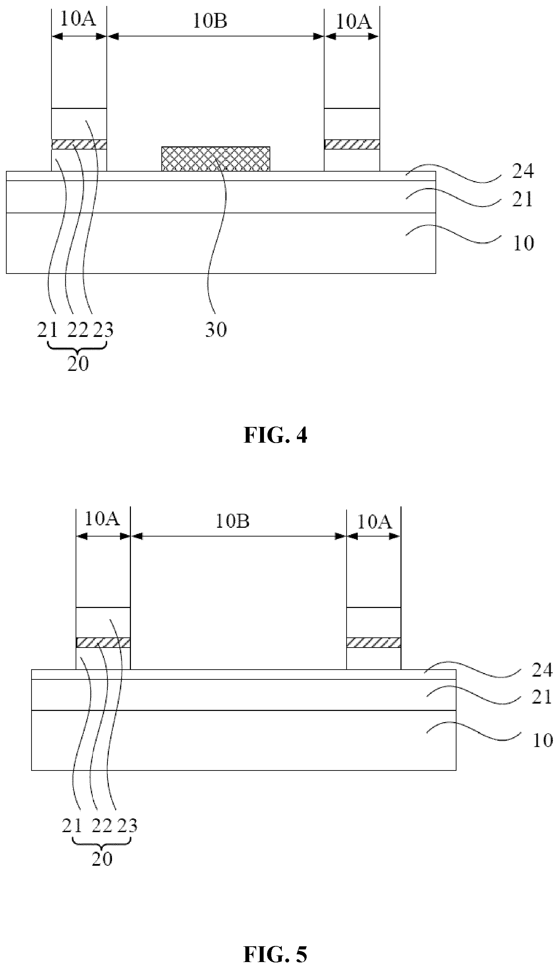

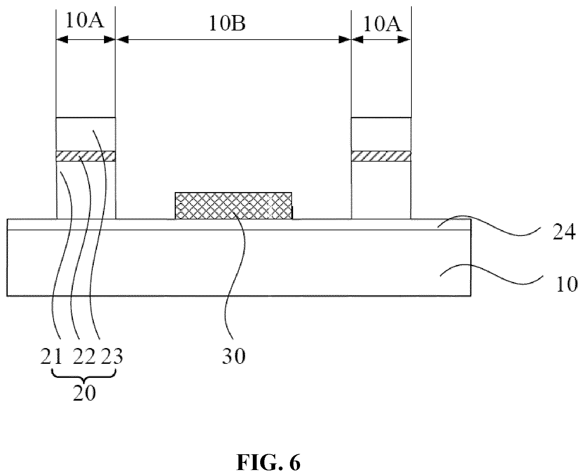

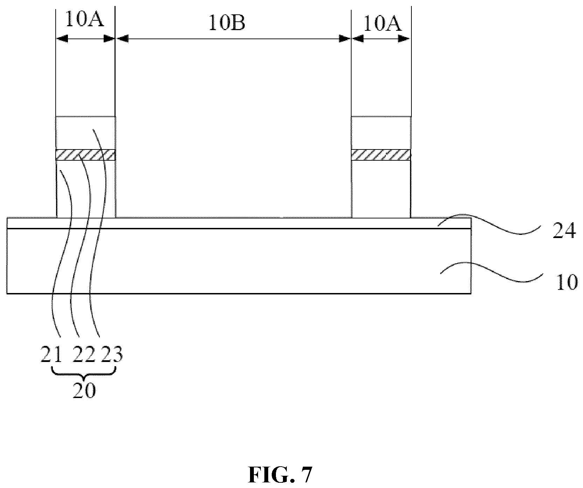

FIG. 4 is another sectional diagram of the VCSEL in FIG. 1 taken along the A1-A2 direction. FIG. 5 is another sectional diagram of the VCSEL in FIG. 1 taken along the B1-B2 direction. FIG. 6 is another sectional diagram of the VCSEL in FIG. 1 taken along the A1-A2 direction. FIG. 7 is another sectional diagram of the VCSEL in FIG. 1 taken along the B1-B2 direction.

Referring to FIGS. 4 to 7, the VCSEL further includes a first ohmic contact layer 24 disposed in the light-emitting regions 10A and the non-light-emitting region 10B. Referring to FIGS. 4 and 5, the first ohmic contact layer 24 is disposed in the first DBR 21; alternatively, referring to FIGS. 6 and 7, the first ohmic contact layer 24 is disposed between the first DBR 21 and the substrate 10. The first ohmic contact layer 24 is provided so that the first ohmic metal layer 30 and the first DBR 21 form a good ohmic contact. A position of the first ohmic contact layer in the embodiments of the present application may be set according to actual situations.

In an example, FIG. 1 shows the light-emitting regions 10A arranged in an array of three rows and five columns and correspondingly shows the emitters 20 arranged in a 3×5 array. The first connecting line L1 is a straight line connecting centers of the emitters 20 in any row, and the second connecting line L2 is a straight line connecting centers of the emitters 20 in any column. Only the first connecting line L1 connecting centers of the emitters 20 in the first row and the second connecting line L2 connecting centers of the emitters 20 in the fourth column are shown in FIG. 1.

In an example, to calculate a spacing between adjacent emitters 20 in the same row and a spacing between adjacent light-emitting unis 20 in the same column, in the embodiments of the present application, a first mathematical model is established below.

As shown in FIG. 1, centers of four adjacent emitters 20 are configured to form a square having a side length of P0. The centers of the four adjacent emitters 20 are represented as O1, O2, O3, and O4, respectively. A center O5 of the first ohmic metal layer 30 is disposed at a center of a diagonal of the square. A spacing between the first ohmic metal layer 30 and the emitter 20 is S0, a radius of the emitter 20 is r1, and the first ohmic metal layer 30 is circular and has a radius of r2. The spacing P0 between the centers of adjacent emitters 20 in the same row and the spacing P0 between the centers of adjacent emitters 20 in the same column satisfy the formula (1) described below.

$$P0 = \frac{2S0 + 2r2 + 2r1}{\sqrt{2}} \qquad (1)$$

For the technical solution in which the first ohmic metal layer is disposed on the first connecting line connecting centers of the emitters in the same row and the second connecting line connecting centers of the emitters in the same column, a second mathematical model is established. The first ohmic metal layer is configured to be disposed at a center of the first connecting line connecting the centers of adjacent emitters in the same row and at a center of the second connecting line connecting the centers of adjacent emitters in the same column, the radius of the emitter is r1, the radius of the first ohmic metal layer is r2, the spacing between the first ohmic metal layer and the emitter is S0, and a spacing P1 between the centers of adjacent emitters in the same row and a spacing P1 between the centers of adjacent emitters in the same column satisfy the formula (2) described below.

$$P1 = 2S0 + 2r2 + 2r1 \qquad (2)$$

By comparing the formula (1) with the formula (2), in the technical solution provided in the embodiments of the present application, the spacing between the centers of adjacent emitters in the same row and the spacing between the centers of adjacent emitters in the same column are reduced, thereby reducing the spacings between adjacent emitters in the same row and the spacings between adjacent emitters in the same column.

As shown in FIG. 1, the spacing P0 between the centers of adjacent emitters 20 in the same row and the spacing P0 between the centers of adjacent emitters 20 in the same column are obtained based on the first mathematical model constructed by four emitters 20. In the process of practical application, m is an integer greater than or equal to 1, n is an integer greater than or equal to 1, the product of m and n is greater than or equal to 2, and it only needs to ensure that a projection of the first ohmic metal layer 30 on the substrate 10 does not overlap with a projection of the first connecting line L1 on the substrate 10 and the projection of the first ohmic metal layer 30 on the substrate 10 does not overlap with a projection of the second connecting line L2 on the substrate 10. Compared with the technical solution in which the first ohmic metal layer is disposed on the first connecting line connecting the emitters in the same row and the second connecting line connected to the emitters in the same column, in the technical solution provided in the embodiments of the present application, the effect of reducing the spacing between adjacent emitters in the same row and the spacing between adjacent emitters in the same column may be achieved, thereby reducing a dimension between the emitters in the VCSEL.

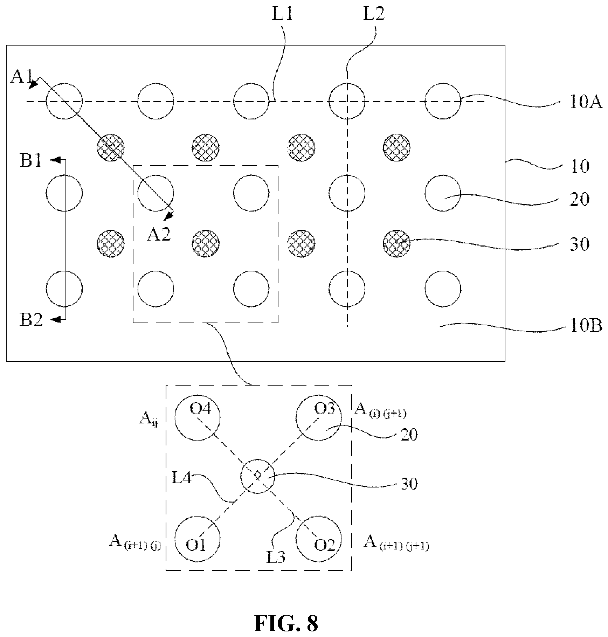

FIG. 8 is a top diagram of another VCSEL according to an embodiment of the present application. Based on the preceding technical solution, in the VCSEL, referring to FIG. 8, m is greater than or equal to 2, n is greater than or equal to 2, and the first ohmic metal layer 30 is disposed in part of the non-light-emitting region 10B among an $A_{ij}$-th emitter 20, an $A_{(i+1)(j)}$-th emitter 20, an $A_{(i)(j+1)}$-th emitter 20, and an $A_{(i+1)(j+1)}$-th emitter 20, where i is greater than or equal to 1 and less than or equal to (m-1) and j is greater than or equal to 1 and less than or equal to (n-1).

For the VCSEL including the emitters 20 arranged in the m×n array, m is greater than or equal to 2, n is greater than or equal to 2, and the first ohmic metal layer 30 is disposed in the part of the non-light-emitting region 10B among four adjacent emitters 20 so that it may be ensured that the projection of the first ohmic metal layer 30 on the substrate 10 does not overlap with the projection of the first connecting line L1 on the substrate 10 and the projection of the first ohmic metal layer 30 on the substrate 10 does not overlap with the projection of the second connecting line L2 on the substrate 10. Compared with the technical solution in which the first ohmic metal layer is disposed on the connecting line connecting the centers of emitters in the same row and the connecting line connecting the centers of the emitters in the same column, in the technical solution provided in this embodiments of the present application, the effect of reducing the spacing between adjacent emitters in the same row and the spacing between adjacent emitters in the same column may be achieved, thereby reducing the dimension of the emitters in the VCSEL.

A shape of the first ohmic metal layer 30 is described below. Based on the preceding technical solution, FIG. 8 is used as an example for description. A shape of the projection of the first ohmic metal layer 30 on the substrate 10 is centrosymmetric, and a center of the shape of the projection of the first ohmic metal layer 30 on the substrate 10 coincides with an intersection point of a third connecting line L3 and a fourth connecting line L4. The third connecting line L3 is a connecting line connecting a center O4 of the $A_{ij}$-th emitter 20 and a center O2 of the $A_{(i+1)(j+1)}$-th emitter 20, and the fourth connecting line L4 is a connecting line between a center O1 of the $A_{(i+1)(j)}$-th emitter 20 and a center O3 of the $A_{(i)(j+1)}$-th emitter 20.

The shape of the projection of the first ohmic metal layer 30 on the substrate 10 is centrosymmetric, and the center of the shape of the projection of the first ohmic metal layer 30 on the substrate 10 coincides with the intersection point of the third connecting line L3 and the fourth connecting line L4 so that it may be ensured that spacings between the first ohmic metal layer 30 and the emitters 20 at two sides are equal in the direction where the third connecting line L3 is located and in the direction where the fourth connecting line L4 is located, thereby simplifying the layout difficulty of the first ohmic metal layer 30 and reducing the preparation difficulty of the VCSEL.

Based on the preceding technical solution, the shape of the projection of the first ohmic metal layer 30 on the substrate 10 includes a circle or a rhombus.

The shape of the projection of the first ohmic metal layer 30 on the substrate 10 includes a circle or a rhombus, thereby simplifying the layout difficulty of the first ohmic metal layer 30 and reducing the preparation difficulty of the VCSEL.

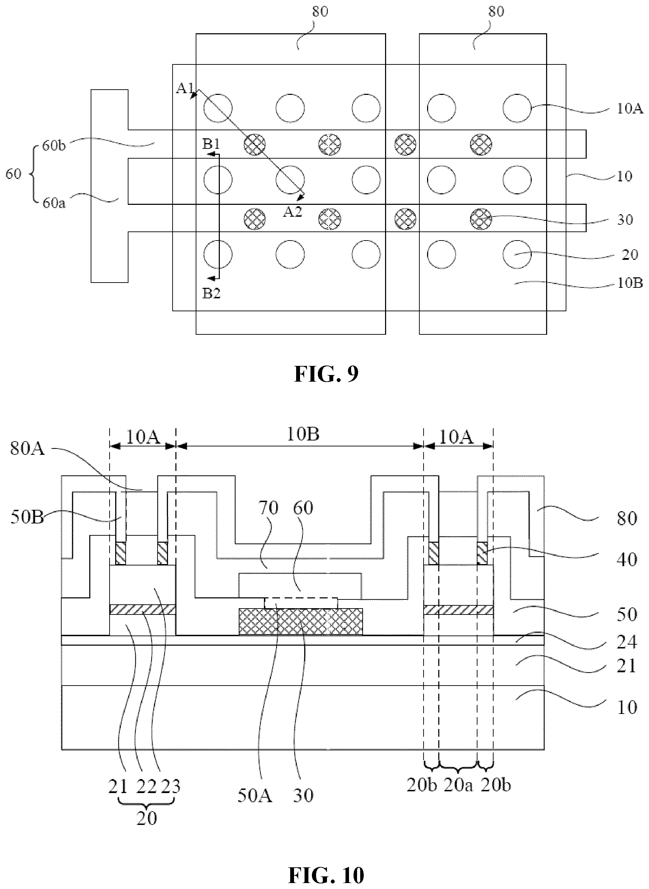

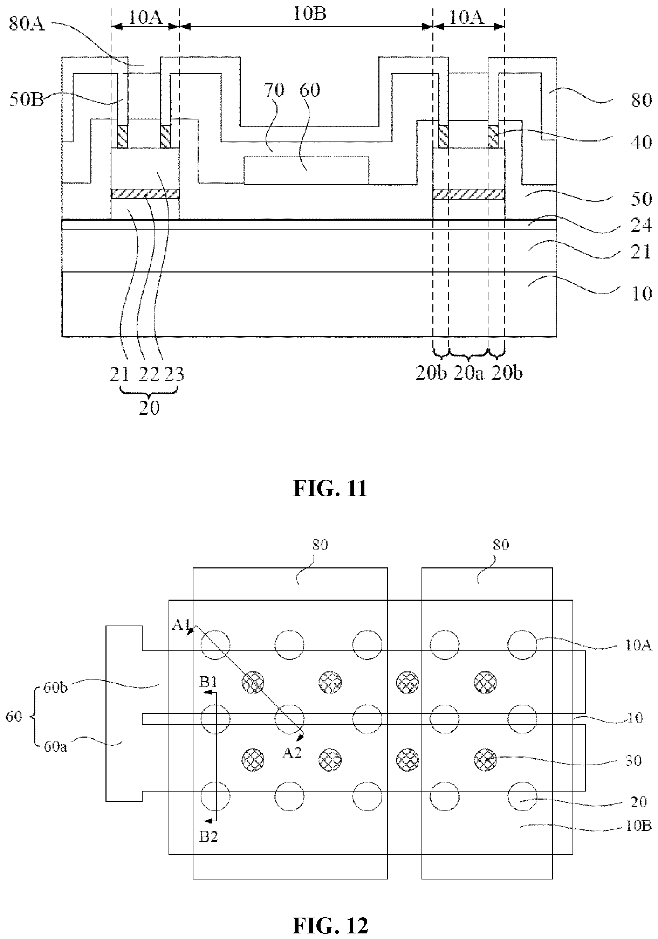

FIG. 9 is a top diagram of another VCSEL according to an embodiment of the present application. FIG. 10 is a sectional diagram of the VCSEL in FIG. 9 taken along the A1-A2 direction. FIG. 11 is a sectional diagram of the VCSEL in FIG. 9 taken along the B1-B2 direction. Referring to FIGS. 9 to 11, the emitter 20 further includes an emission window 20a and an edge region 20b surrounding the emission window 20a, where the emission window 20a and the edge region 20b are both disposed on a surface of a side of the second DBR 23 facing away from the substrate 10. The VCSEL further includes a second ohmic metal layer 40, a first passivation layer 50, a first pad 60, a second passivation layer 70, and a second pad 80. The second ohmic metal layer 40 is disposed on the surface of the side of the second DBR 23 facing away from the substrate 10 and disposed in the edge region 20b. The first passivation layer 50 is disposed on a side of the first ohmic metal layer 30 facing away from the substrate 10 and disposed in the light-emitting regions 10A and the non-light-emitting region 10B, and the first passivation layer 50 is provided with a first via 50A, where at least part of the first ohmic metal layer 30 is exposed from the first via 50A. The first pad 60 is disposed on a side of the first passivation layer 50 facing away from the substrate 10, a projection of the first pad 60 on the substrate 10 does not overlap with a projection of the emission window 20a of a respective emitter 20 on the substrate 10, and the first pad 60 is connected to the first ohmic metal layer 30 through the first via 50A. The second passivation layer 70 is disposed on a surface of the first pad 60 facing away from the substrate 10 and covers the light-emitting regions 10A and the non-light-emitting region 10B. The second passivation layer 70 and the first passivation layer 50 are provided with a second via 50B, where at least part of the second ohmic metal layer 40 is exposed from the second via 50B. The second pad 80 is disposed on a surface of a side of the second passivation layer 70 facing away from the substrate 10, a projection of the second pad 80 on the substrate 10 does not overlap with the projection of the emission window 20a of the respective emitter 20 on the substrate 10, and the second pad 80 is connected to the second ohmic metal layer 40 through the second via 50B.

The first passivation layer 50 is configured to protect the first ohmic metal layer 30 and the second ohmic metal layer 40, the first pad 60 is connected to the first ohmic metal layer 30 through the first via 50A, and the second pad 80 is connected to the second ohmic metal layer 40 through the second via 50B so as to enable the first pad 60 to flow an external current signal into the first DBR 21 of the emitter 20 through the first ohmic metal layer 30 or enable the second pad 80 to flow an external current signal into the second DBR 23 through the second ohmic metal layer 40.

Refractive indices of the first DBR 21 and the second DBR 23 are different. In the case where a thickness of the first DBR 21 and a thickness of the second DBR 23 are an integer multiple of a quarter of a preset wavelength, the first DBR 21 and the second DBR 23 may transmit light of the preset wavelength. The first DBR 21 and the second DBR 23 are semiconductor materials that are grown periodically, that is, the first DBR 21 and the second DBR 23 are periodic multi-layer structure materials that are formed by alternately growing different film layers. The active layer 22 is a quantum material of well luminescent and emits light under the action of a current signal, and the emitted light is reflected between the first DBR 21 and the second DBR 23 and then exits from the second DBR 23. The embodiments of the present application include the technical solution in which the light emitted by the VCSEL exits from the second DBR 23 shown in the figures and may further include the technical solution in which the light emitted by the VCSEL exits from the first DBR 21.

In the embodiments of the present application, the projection of the first ohmic metal layer 30 on the substrate 10 does not overlap with the projection of the first connecting line L1 on the substrate 10, the projection of the first ohmic metal layer 30 on the substrate 10 does not overlap with the projection of the second connecting line L2 on the substrate 10, the first pad 60 applies an external current signal to the first DBR 21 of the emitter 20 through the first ohmic metal layer 30, the second pad 80 applies an external current signal to the second DBR 23 through the second ohmic metal layer 40, the active layer 22 emits light under the action of the current signal, and the emitted light is reflected between the first DBR 21 and the second DBR 23 and then exits. Compared with the VCSEL in which the first ohmic metal layer is disposed on a straight line connecting the centers of the emitters in the same row and a straight line connecting the centers of the emitters in the same column, the VCSEL provided in the embodiments of the present application may achieve the effect of reducing the spacing between adjacent emitters in the same row and the spacing between adjacent emitters in the same column, thereby reducing the dimension of the emitters in the VCSEL. In addition, the projection of the first pad 60 on the substrate 10 does not overlap with the projection of the emission window 20a of the emitter 20 on the substrate 10, and the projection of the second pad 80 on the substrate 10 does not overlap with the projection of the emission window 20a of the emitter 20 on the substrate 10, thereby preventing the first pad and the second pad from blocking the light emitted from the emission window and improving the light output efficiency of the VCSEL.

A position of the projection of the first pad 60 on the substrate 10 is described below.

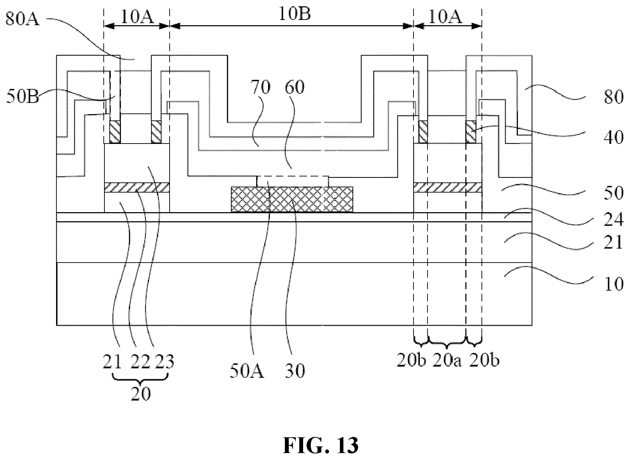

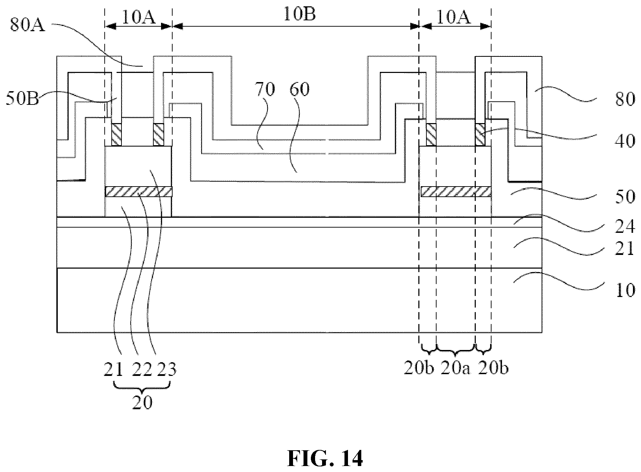

FIG. 12 is a top diagram of another VCSEL according to an embodiment of the present application. FIG. 13 is a sectional diagram of the VCSEL in FIG. 12 taken along the A1-A2 direction. FIG. 14 is a sectional diagram of the VCSEL in FIG. 12 taken along the B1-B2 direction. Based on the preceding technical solution, referring to FIGS. 9 to 11, the first pad 60 is disposed in the non-light-emitting region 10B; alternatively, referring to FIGS. 12 to 14, the first pad 60 is disposed in the non-light-emitting region 10B and the edge region 20b of the emitter 20.

The first pad 60, except for a part connected to the first ohmic metal layer 30, is insulated from the first DBR 21 through the first passivation layer 50. Therefore, the projection of the first pad 60 on the substrate 10 does not overlap with the projection of the emission window 20a of the emitter 20 on the substrate 10, so that the first pad 60 transmits a current signal to the first DBR 21 without affecting the light of the emitter 20 to exit from the emission window 20a. Therefore, in the technical solution provided in the embodiments of the present application, the first pad 60 is disposed in the non-light-emitting region 10B shown in FIGS. 9 to 11; alternatively, the first pad 60 is disposed in the non-light-emitting region 10B and the edge region 20b of the emitter 20 shown in FIGS. 12 to 14, so that the layout flexibility of the first pad may be improved.

Based on the preceding technical solution, referring to FIGS. 10 and 11 and FIGS. 13 and 14, the second pad 80 is provided with m×n light emission windows 80A, and a projection of the light emission window 80A on the substrate 10 overlaps with the projection of a respective emission window 20a on the substrate 10.

The number of light emission windows 80A provided on the second pad 80 is the same as the number of the emitters 20, and the projection of the light emission window 80A on the substrate 10 overlaps with the projection of the emission window 20a on the substrate 10, thereby preventing the second pad from blocking the light emitted from the emission window and improving the light output efficiency of the VCSEL. The light emission windows are defined by performing a photolithography process on a metal film layer where the second pad is located.

Based on the preceding technical solution, referring to FIGS. 9 and 12, the first pad 60 includes a main connecting-portion 60a and at least one first-direction strip-shaped sub-connecting-portion 60b connected to the main connecting-portion 60a, where the main connecting-portion 60a is disposed on a side of the emitters 20 arranged in the m×n array, and the first-direction strip-shaped sub-connecting-portion 60b is disposed between two adjacent rows of the emitters 20.

The first pad 60 includes the main connecting-portion 60a and at least one first-direction strip-shaped sub-connecting-portion 60b connected to the main connecting-portion 60a, where the first-direction strip-shaped sub-connecting-portion 60b is disposed between two adjacent rows of the emitters 20, the main connecting-portion 60a is connected to an external driver circuit, the main connecting-portion 60a applies an external drive signal to the first DBR 21 through the first-direction strip-shaped sub-connecting-portion 60b, and the first-direction strip-shaped sub-connecting-portion 60b is disposed in the non-light-emitting region 10B shown in FIGS 9 to 11, or the first-direction strip-shaped sub-connecting-portion 60b is disposed in the non-light-emitting region 10B and the edge region 20b of the emitter 20 shown in FIGS. 12 to 14, thereby preventing the first pad from blocking the light emitted from the emission window and improving the light output efficiency of the VCSEL.

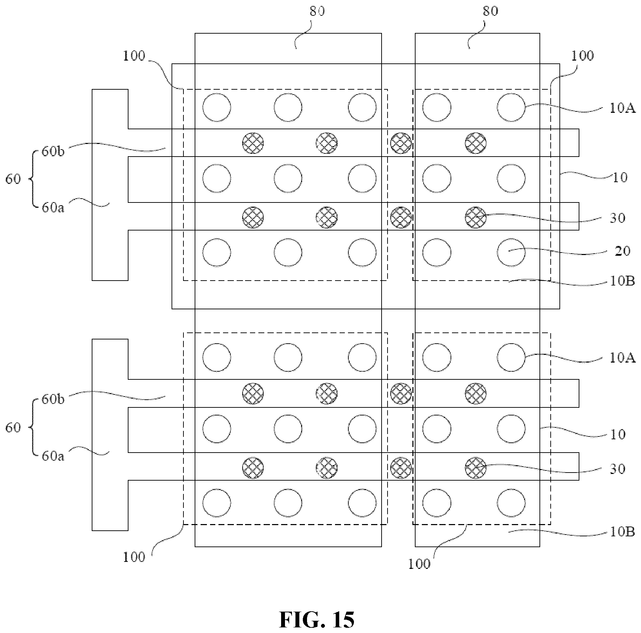

FIG. 15 is a top diagram of another VCSEL according to an embodiment of the present application. Based on the preceding technical solution, referring to FIG. 15, the emitters arranged in the m×n array are divided into Q light emission control regions 100, a number of first pads 60 is K1, the number of second pads 80 is K2, Q is equal to a product of K1 and K2, and Q is greater than or equal to 1 and less than or equal to the product of m and n.

In an example, m has a value of 6, n has a value of 5, Q has a value of 4, the number of first pads 60 is two, and the number of second pads 80 is two. The number of the light emission control regions 100, the number of first pads 60, and the number of second pads 80 are not limited in the embodiments of the present application.

The emitters 20 arranged in the m×n array are divided into the Q light emission control regions 100 so that the emitters 20 belonging to the same light emission control region 100 are lighted and driven to emit light through current signals applied by the first pads 60 and the second pads 80.

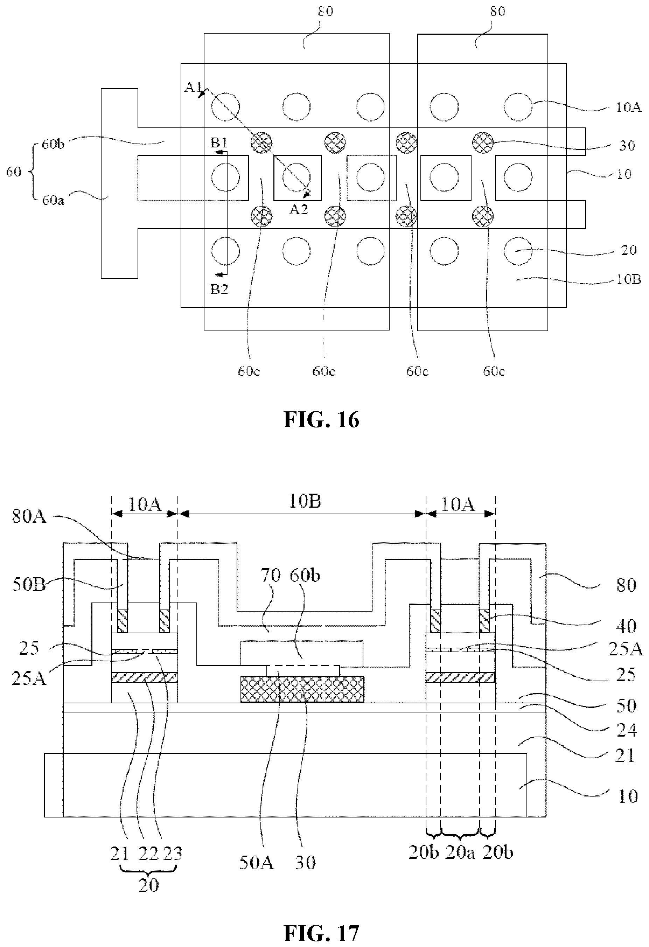

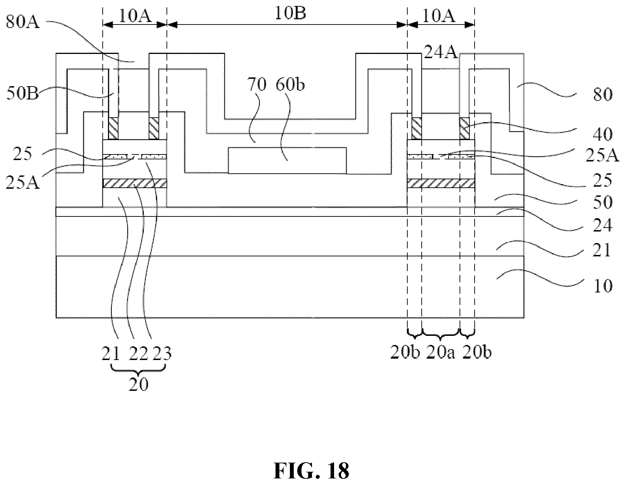

FIG. 16 is a top diagram of another VCSEL according to an embodiment of the present application. FIG. 17 is a sectional diagram of the VCSEL in FIG. 16 taken along the A1-A2 direction. FIG. 18 is a sectional diagram of the VCSEL in FIG. 16 taken along the B1-B2 direction. Based on the preceding technical solution, referring to FIGS. 16 to 18, the first pad 60 further includes at least one second-direction strip-shaped sub-connecting-portion 60c, where each of the at least one second-direction strip-shaped sub-connecting-portion 60c is connected to a respective one of the at least one first-direction strip-shaped sub-connecting-portion 60b. In the case where the first pad 60 includes multiple first-direction strip-shaped sub-connecting-portions 60b and multiple second-direction strip-shaped sub-connecting-portions 60c, two adjacent second-direction strip-shaped sub-connecting-portions 60c and two adjacent respective first-direction strip-shaped sub-connecting-portions 60b form a hashtag-shaped structure, each of the multiple second-direction strip-shaped sub-connecting-portion 60c is disposed between two adjacent columns of the emitters 20, and a projection of each of the multiple second-direction strip-shaped sub-connecting-portions 60c on the substrate 10 does not overlap with the projection of the emission window 20a of the emitter 20 on the substrate 10.

Two adjacent second-direction strip-shaped sub-connecting-portions 60c and two adjacent respective first-direction strip-shaped sub-connecting-portions 60b form the hashtag-shaped structure, thereby improving the uniformity of the current flowing through the first pad and further improving the uniformity of light emission of different emitters.

Based on the preceding technical solution, referring to FIGS. 16 and 17, the emitter 20 further includes a confining oxidation layer 25, where the confining oxidation layer 25 is disposed in the second DBR 23 and provided with an oxidation aperture 25A, where the oxidation aperture 25A is an optical aperture defined for the emitter 20.

The active layer 22 is a quantum material of well luminescent and emits light under the action of a current signal, and the emitted light is reflected between the first DBR 21 and the second DBR 23 and then exits from the second DBR 23. The embodiments of the present application include the technical solution in which the light emitted by the VCSEL exits from the oxidation aperture 24A shown in the figures.

The projection of the emission window 20a on the substrate 10 covers a projection of the oxidation aperture 24A on the substrate 10. In an example, the confining oxidation layer 25 is made from oxidized aluminum, and accordingly, the oxidation aperture 24A is aluminum.

In FIGS. 15 to 18, the structure of the first pad 60 shown in FIG. 9 is used as an example for description, and the technical solution corresponding to FIGS. 15 to 18 is applicable to the case shown in FIG. 12 where the first pad 60 is disposed in the non-light-emitting region 10B and the edge region 20b of the emitter 20.

In the embodiments of the present application, the first DBR is P-type and the second DBR is N-type; or the first DBR is N-type and the second DBR is P-type.

In the VCSEL shown in FIGS. 8 to 18, the first ohmic contact layer 24 is disposed in the first DBR 21. The VCSEL shown in FIGS. 8 to 18 is also applicable to the technical solution in which the first ohmic contact layer 24 is disposed between the first DBR 21 and the substrate 10.

**Claims**

**1.** A vertical cavity surface emitting laser, VCSEL, comprising:

a substrate (10), wherein a surface of the substrate (10) comprises light-emitting regions arranged in an array of m rows and n columns and a non-light-emitting region surrounding each of the light-emitting regions, wherein m is an integer greater than or equal to 2, n is an integer greater than or equal to 2, and a product of m and n is greater than or equal to 4;

emitters (20) arranged in an m×n array, wherein each of the emitters (20) comprises a first distributed Bragg reflection, DBR (21) disposed on the surface of the substrate (10), an active layer (22) disposed on a side of the first DBR (21) facing away from the substrate (10), and a second DBR (22) disposed on a side of the active layer (22) facing away from the substrate (10), wherein a part of the first DBR (21) is disposed in a respective light-emitting region of the light-emitting regions, and the active layer (22) and the second DBR (22) are disposed in the respective light-emitting region; and

a first ohmic metal layer (30) disposed on a surface of the first DBR (21) facing away from the substrate (10) and disposed in the non-light-emitting region, wherein the first ohmic metal layer (30) is configured to provide an ohmic contact to the first DBR (21), a projection of the first ohmic metal layer (30) on the substrate (10) does not overlap with a projection of a first connecting line on the substrate (10), and the projection of the first ohmic metal layer (30) on the substrate (10) does not overlap with a projection of a second connecting line on the substrate (10), wherein the first connecting line is a straight line where a connecting line connecting centers of emitters (20) in a same row is located, the second connecting line is a straight line where a connecting line connecting centers of emitters (20) in a same column is located, and centers of four adjacent emitters (20) of the array are configured to form a square, such that the first connecting line is orthogonal to the second connecting line;

wherein the VCSEL is **characterized in that** each of the emitters (20) further comprises an emission window (20a) and an edge region surrounding the emission window (20a), wherein the emission window (20a) and the edge region are both disposed on a surface of a side of the second DBR (22) facing away from the substrate (10);

wherein the VCSEL further comprises a second ohmic metal layer (40), a first passivation layer (50), a first pad (60), a second passivation layer (70), and a second pad (80);

wherein the second ohmic metal layer (40) is disposed on the surface of the side of the second DBR (22) facing away from the substrate (10) and disposed in the edge region;

the first passivation layer (50) is disposed on a side of the first ohmic metal layer (30) facing away from the substrate (10) and disposed in the light-emitting regions and the non-light-emitting region, and the first passivation layer (50) is provided with a first via (50A), wherein at least part of the first ohmic metal layer (30) is exposed from the first via (50A);

the first pad (60) is disposed on a side of the first passivation layer (50) facing away from the substrate (10), a projection of the first pad (60) on the substrate (10) does not overlap with a projection of the emission window (20a) of a respective emitter (20) on the substrate (10), and the first pad (60) is connected to the first ohmic metal layer (30) through the first via (50A);

the second passivation layer (70) is disposed on a surface of the first pad (60) facing away from the substrate (10) and covers the light-emitting regions and the non-light-emitting region;

the second passivation layer (70) and the first passivation layer (50) are provided with a second via (50B), wherein at least part of the second ohmic metal layer (40) is exposed from the second via (50B); and

the second pad (80) is disposed on a surface of a side of the second passivation layer (70) facing away from the substrate (10), a projection of the second pad (80) on the substrate (10) does not overlap with the projection of the emission window (20a) of the respective emitter (20) on the substrate (10), and the second pad (80) is connected to the second ohmic metal layer (40) through the second via (50B).

2. The VCSEL of claim 1, wherein each of the emitters (20) further comprises a first ohmic contact layer (24) disposed in a respective light-emitting region and the non-light-emitting region, wherein the first ohmic contact layer (24) is disposed in the first DBR (21), and the ohmic contact between the first ohmic metal layer (30) and the first DBR (21) is formed through the first ohmic contact layer (24).

3. The VCSEL of claim 1, wherein the first ohmic metal layer (30) is disposed in part of the non-light-emitting region among an $A_{ij}$-th emitter (20), an $A_{(i+1)(j)}$-th emitter (20), an $A_{(i)(j+1)}$-th emitter (20), and an $A_{(i+1)(j+1)}$-th emitter (20), wherein i is greater than or equal to 1 and less than or equal to (m-1), and j is greater than or equal to 1 and less than or equal to (n-1).

4. The VCSEL of claim 3, wherein a shape of the projection of the first ohmic metal layer (30) on the substrate (10) is centrosymmetric, and a center of the shape of the projection of the first ohmic metal layer (30) on the substrate (10) coincides with an intersection point of a third connecting line and a fourth connecting line;

wherein the third connecting line is a straight line where a connecting line connecting a center of the $A_{ij}$-th emitter (20) and a center of the $A_{(i-1)(j+1)}$-th emitter (20) is located, and the fourth connecting line is a straight line where a connecting line connecting a center of the $A_{(i+1)(j)}$-th emitter (20) and a center of the $A_{(i)(j+1)}$-th emitter (20) is located.

5. The VCSEL of any one of claims 1 to 4, wherein the shape of the projection of the first ohmic metal layer (30) on the substrate (10) comprises a circle or a rhombus.

6. The VCSEL of claim 1, wherein the first pad (60) is disposed in the non-light-emitting region; or
the first pad (60) is disposed in the non-light-emitting region and the edge region of the respective emitter (20).

7. The VCSEL of claim 1, wherein the second pad (80) is provided with m×n light emission windows (20a), and a projection of each of the light emission windows (20a) on the substrate (10) overlaps with a projection of a respective emission window (20a) on the substrate (10).

8. The VCSEL of claim 1, wherein the first pad (60) comprises a main connecting-portion and at least one first-direction strip-shaped sub-connecting-portion connected to the main connecting-portion, wherein the main connecting-portion is disposed on a side of the emitters (20) arranged in the m×n array, and each of the at least one first-direction strip-shaped sub-connecting-portion is disposed between two adjacent rows of the emitters (20).

9. The VCSEL of claim 8, wherein the emitters (20) arranged in the m×n array are divided into Q light emission control regions, a number of first pads (60) is K1, a number of second pads (80) is K2, Q is equal to a product of K1 and K2, and Q is greater than or equal to 1 and less than or equal to the product of m and n.

10. The VCSEL of claim 8, wherein each of the first pads (60) further comprises at least one second-direction strip-shaped sub-connecting-portion, wherein each of the at least one second-direction strip-shaped sub-connecting-portion is connected to a respective one of the at least one first-direction strip-shaped sub-connecting-portion;
wherein in a case where each of the first pads (60) comprises a plurality of first-direction strip-shaped sub-connecting-portions and a plurality of second-direction strip-shaped sub-connecting-portions, two adjacent ones of the plurality of second-direction strip-shaped sub-connecting-portions and two respective adjacent ones of the plurality of first-direction strip-shaped sub-connecting-portions form a hashtag-shaped structure, each of the plurality of second-direction strip-shaped sub-connecting-portions is disposed between two adjacent columns of the emitters (20), and a projection of each of the plurality of second-direction strip-shaped sub-connecting-portions on the substrate (10) does not overlap with the projection of the emission window (20a) of a respective one of the emitters (20) on the substrate (10).

11. The VCSEL of claim 1, wherein each of the emitters (20) further comprises a confining oxidation layer (25), wherein the confining oxidation layer (25) is disposed in the second DBR (22) and provided with an oxidation aperture (25A), and the oxidation aperture (25A) is an optical aperture defined for the respective one of the emitters (20).

**Patentansprüche**

1. Oberflächenemittierender Laser mit vertikaler Kavität (kurz: VCSEL), umfassend:

ein Substrat (10), wobei eine Oberfläche des Substrats (10) lichtemittierende Bereiche, die in einer Anordnung von m Zeilen und n Spalten angeordnet sind, und einen nicht lichtemittierenden Bereich umfasst, der jeden der lichtemittierenden Bereiche umgibt, wobei m eine ganze Zahl größer oder gleich 2, n eine ganze Zahl größer oder gleich 2 und das Produkt aus m und n größer oder gleich 4 ist;
Emitter (20), die in einer m×n-Anordnung angeordnet sind, wobei jeder der Emitter (20) eine erste verteilte Bragg-Reflexion (kurz: DBR) (21), die auf der Oberfläche des Substrats (10) angeordnet ist, eine aktive Schicht (22), die auf einer vom Substrat (10) abgewandten Seite der ersten DBR (21) angeordnet ist, und eine zweite DBR (22), die auf einer vom Substrat (10) abgewandten Seite der aktiven Schicht (22) angeordnet ist, umfasst, wobei ein Teil der ersten DBR (21) in einem jeweiligen lichtemittierenden Bereich der lichtemittierenden Bereiche angeordnet ist, während die aktive Schicht (22) und die zweite DBR (22) in dem jeweiligen lichtemittierenden Bereich angeordnet sind; und
eine erste ohmsche Metallschicht (30), die auf einer vom Substrat (10) abgewandten Oberfläche des ersten DBR (21) angeordnet ist und sich in dem nicht lichtemittierenden Bereich befindet, wobei die erste ohmsche Metallschicht (30) dazu konfiguriert ist, einen ohmschen Kontakt zur ersten DBR (21) herzustellen, wobei sich eine Projektion der ersten ohmschen Metallschicht (30) auf das Substrat (10) nicht mit einer Projektion einer ersten Verbindungslinie auf das Substrat (10) überlappt, und wobei sich die Projektion der ersten ohmschen Metallschicht (30) auf das Substrat (10) nicht mit einer Projektion einer zweiten Verbindungslinie auf das Substrat (10) überlappt, wobei die erste Verbindungslinie eine gerade Linie ist, auf der sich eine Verbindungslinie befindet, die die Mittelpunkte der Emitter (20) in derselben Reihe verbindet, während die zweite Verbindungslinie eine gerade Linie ist, auf der sich eine Verbindungslinie befindet, die die Mittelpunkte der Emitter (20) in derselben Spalte verbindet, und wobei die Mittelpunkte von vier benachbarten Emittern (20) der Anordnung so konfiguriert sind, dass sie ein Quadrat bilden, so dass die erste Verbindungslinie orthogonal zur zweiten Verbindungslinie ist;
wobei der VCSEL **dadurch gekennzeichnet ist, dass** jeder der Emitter (20) ferner ein Emissionsfenster (20a) und einen das Emissionsfenster (20a) umgebenden Randbereich umfasst, wobei das Emissionsfenster (20a) und der Randbereich beide auf einer Oberfläche einer vom Substrat (10) abgewandten Seite der zweiten DBR (22) angeordnet sind;
wobei der VCSEL ferner eine zweite ohmsche Metallschicht (40), eine erste Passivierungsschicht (50), ein erstes Pad (60), eine zweite Passivierungsschicht (70) und ein zweites Pad (80) umfasst;
wobei die zweite ohmsche Metallschicht (40) auf der Oberfläche der vom Substrat (10) abgewandten Seite des zweiten DBR (22) angeordnet ist und sich im Randbereich befindet;
wobei die erste Passivierungsschicht (50) auf einer vom Substrat (10) abgewandten Seite der ersten ohmschen Metallschicht (30) angeordnet ist und sich in den lichtemittierenden Bereichen und dem nicht lichtemittierenden Bereich befindet, und wobei die erste Passivierungsschicht (50) mit einer ersten Durchkontaktierung (50A) versehen ist, wobei mindestens ein Teil der ersten ohmschen Metallschicht (30) an der ersten Durchkontaktierung (50A) freiliegt;
wobei das erste Pad (60) auf einer vom Substrat (10) abgewandten Seite der ersten Passivierungsschicht (50) angeordnet ist, wobei sich eine Projektion des ersten Pads (60) auf das Substrat (10) nicht mit einer Projektion des Emissionsfensters (20a) eines jeweiligen Emitters (20) auf das Substrat (10) überlappt, und wobei das erste Pad (60) über die erste Durchkontaktierung (50A) mit der ersten ohmschen Metallschicht (30) verbunden ist;
wobei die zweite Passivierungsschicht (70) auf einer vom Substrat (10) abgewandten Oberfläche des ersten Pads (60) angeordnet ist und die lichtemittierenden Bereiche und den nicht lichtemittierenden Bereich bedeckt;
wobei die zweite Passivierungsschicht (70) und die erste Passivierungsschicht (50) mit einer zweiten Durchkontaktierung (50B) versehen sind, wobei mindestens ein Teil der zweiten ohmschen Metallschicht (40) an der zweiten Durchkontaktierung (50B) freiliegt; und
wobei das zweite Pad (80) auf einer Oberfläche einer vom Substrat (10) abgewandten Seite der zweiten Passivierungsschicht (70) angeordnet ist, wobei sich eine Projektion des zweiten Pads (80) auf das Substrat (10) nicht mit der Projektion des Emissionsfensters (20a) des jeweiligen Emitters (20) auf das Substrat (10) überlappt, und wobei das zweite Pad (80) über die zweite Durchkontaktierung (50B) mit der zweiten ohmschen Metallschicht (40) verbunden ist.

2. VCSEL nach Anspruch 1, wobei jeder der Emitter (20) ferner eine erste ohmsche Kontaktschicht (24) umfasst, die in einem jeweiligen lichtemittierenden Bereich und dem nicht lichtemittierenden Bereich angeordnet ist, wobei die erste ohmsche Kontaktschicht (24) in der ersten DBR (21) angeordnet ist und der ohmsche Kontakt zwischen der ersten ohmschen Metallschicht (30) und der ersten DBR (21) durch die erste ohmsche Kontaktschicht (24) gebildet ist.

3. VCSEL nach Anspruch 1, wobei die erste ohmsche Metallschicht (30) in einem Teil des nicht lichtemittierenden Bereichs zwischen einem $A_{ij}$-ten Emitter (20), einem $A_{(i+1)(j)}$-ten Emitter (20), einem $A_{(i)(j+1)}$-ten Emitter (20) und einem $A_{(i+1)(j+1)}$-ten Emitter (20) angeordnet ist, wobei i größer oder gleich 1 und kleiner oder gleich (m-1) und j größer oder gleich 1 und kleiner oder gleich (n-1) ist.

4. VCSEL nach Anspruch 3, wobei eine Form der Projektion der ersten ohmschen Metallschicht (30) auf das Substrat (10) zentrosymmetrisch ist und ein Mittelpunkt der Form der Projektion der ersten ohmschen Metallschicht (30) auf das Substrat (10) mit einem Schnittpunkt einer dritten Verbindungslinie und einer vierten Verbindungslinie zusammenfällt;
wobei die dritte Verbindungslinie eine gerade Linie ist, auf der sich eine Verbindungslinie befindet, die einen Mittelpunkt des $A_{ij}$-ten Emitters (20) und einen Mittelpunkt des $A_{(i+1)(j+1)}$-ten Emitters (20) verbindet, während die vierte Verbindungslinie eine gerade Linie ist, auf der eine Verbindungslinie befindet, die einen Mittelpunkt des $A_{(i+1)(j)}$-ten Emitters (20) und einen Mittelpunkt des $A_{(i)(j+1)}$-ten Emitters (20) verbindet.

5. VCSEL nach einem der Ansprüche 1 bis 4, wobei die Form der Projektion der ersten ohmschen Metallschicht (30) auf das Substrat (10) einen Kreis oder eine Raute umfasst.

6. VCSEL nach Anspruch 1, wobei das erste Pad (60) in dem nicht lichtemittierenden Bereich angeordnet ist; oder wobei das erste Pad (60) in dem nicht lichtemittierenden Bereich und dem Randbereich des jeweiligen Emitters (20) angeordnet ist.

7. VCSEL nach Anspruch 1, wobei das zweite Pad (80) mit m×n Lichtemissionsfenstern (20a) versehen ist, wobei sich eine Projektion jedes der Lichtemissionsfenster (20a) auf das Substrat (10) mit einer Projektion eines jeweiligen Emissionsfensters (20a) auf das Substrat (10) überlappt.

8. VCSEL nach Anspruch 1, wobei das erste Pad (60) einen Hauptverbindungsabschnitt und mindestens einen streifenförmigen Unterverbindungsabschnitt in erster Richtung umfasst, der mit dem Hauptverbindungsabschnitt verbunden ist, wobei der Hauptverbindungsabschnitt auf einer Seite der in der m×n-Anordnung angeordneten Emitter (20) angeordnet ist und jeder des mindestens einen streifenförmigen Unterverbindungsabschnitts in erster Richtung zwischen zwei benachbarten Reihen der Emitter (20) angeordnet ist.

9. VCSEL nach Anspruch 8, wobei die in der m×n-Anordnung angeordneten Emitter (20) in Q Lichtemissionssteuerungsbereiche unterteilt sind, wobei die Anzahl der ersten Pads (60) K1 und die Anzahl der zweiten Pads (80) K2 beträgt, wobei Q gleich dem Produkt aus K1 und K2 ist, und wobei Q größer oder gleich 1 und kleiner oder gleich dem Produkt aus m und n ist.

10. VCSEL nach Anspruch 8, wobei jedes der ersten Pads (60) ferner mindestens einen streifenförmigen Unterverbindungsabschnitt in zweiter Richtung umfasst, wobei jeder des mindestens einen streifenförmigen Unterverbindungsabschnitts in zweiter Richtung mit einem jeweiligen des mindestens einen streifenförmigen Unterverbindungsabschnitts in erster Richtung verbunden ist;
wobei in einem Fall, in dem jedes der ersten Pads (60) mehrere streifenförmige Unterverbindungsabschnitte in erster Richtung und mehrere streifenförmige Unterverbindungsabschnitte in zweiter Richtung umfasst, zwei benachbarte der mehreren streifenförmigen Unterverbindungsabschnitte in zweiter Richtung und zwei jeweilige benachbarte der mehreren streifenförmigen Unterverbindungsabschnitte in erster Richtung eine hashtagförmige Struktur bilden, wobei jeder der mehreren streifenförmigen Unterverbindungsabschnitte in zweiter Richtung zwischen zwei benachbarten Spalten der Emitter (20) angeordnet ist, und wobei sich eine Projektion jedes der mehreren streifenförmigen Unterverbindungsabschnitte in zweiter Richtung auf das Substrat (10) nicht mit der Projektion des Emissionsfensters (20a) eines jeweiligen der Emitter (20) auf das Substrat (10) überlappt.

11. VCSEL nach Anspruch 1, wobei jeder der Emitter (20) ferner eine begrenzende Oxidationsschicht (25) umfasst, wobei die begrenzende Oxidationsschicht (25) in der zweiten DBR (22) angeordnet und mit einer Oxidationsöffnung (25A) versehen ist, wobei die Oxidationsöffnung (25A) eine für den jeweiligen der Emitter (20) definierte optische Öffnung ist.

**Revendications**

1. Laser émetteur à surface à cavité verticale, VCSEL, comprenant :

un substrat (10), dans lequel une surface du substrat (10) comprend des régions lumineuses disposées en réseau de m rangées et n colonnes et une région non lumineuse entourant chacune des régions lumineuses, où m est un entier supérieur ou égal à 2, n est un entier supérieur ou égal à 2, et un produit de m et n est supérieur ou égal à 4 ;
des émetteurs (20) disposés en réseau m×n, dans lesquels chacun des émetteurs (20) comprend un premier réflecteur Bragg distribué, DBR (21), disposé sur la surface du substrat (10), une couche active (22) disposée sur un côté du premier DBR (21) s'éloignant du substrat (10), et un deuxième DBR (22) disposé sur un côté de la couche active (22) s'éloignant du substrat (10), une partie du premier DBR (21) étant disposée dans une région lumineuse respective des régions lumineuses, et la couche active (22) ainsi que le deuxième DBR (22) étant disposés dans la région lumineuse respective ; et
une première couche métallique ohmique (30) disposée sur une surface du premier DBR (21) s'éloignant du substrat (10) et disposée dans la région non lumineuse, dans laquelle la première couche métallique ohmique (30) est configurée pour s'assurer un contact ohmique avec le premier DBR (21), une projection de la première couche métallique ohmique (30) sur le substrat (10) ne chevauche pas une projection d'une première ligne de liaison sur le substrat (10), et la projection de la première couche métallique ohmique (30) sur le substrat (10) ne chevauche pas une projection d'une deuxième ligne de liaison sur le substrat (10), la première ligne de liaison étant une ligne droite où se trouve une ligne de liaison reliant des centres des émetteurs (20) dans une même rangée, la deuxième ligne de liaison étant une ligne droite où se trouve une ligne de liaison reliant des centres des émetteurs (20) dans une même colonne, et des centres de quatre émetteurs (20) adjacents du réseau étant configurés pour former un carré, de sorte que la première ligne de liaison soit orthogonale à la deuxième ligne de liaison ;

dans lequel le VCSEL est **caractérisé en ce que** chacun des émetteurs (20) comprend en outre une fenêtre d'émission (20a) et une région périphérique entourant la fenêtre d'émission (20a), la fenêtre d'émission (20a) et la région périphérique étant toutes deux disposées sur une surface d'un côté du deuxième DBR (22) s'éloignant du substrat (10) ;

dans lequel le VCSEL comprend en outre une deuxième couche métallique ohmique (40), une première couche de passivation (50), un premier coussin (60), une deuxième couche de passivation (70) et un deuxième coussin (80) ;

dans lequel la deuxième couche métallique ohmique (40) est disposée sur la surface du côté du deuxième DBR (22) s'éloignant du substrat (10) et est disposée dans la région périphérique ;

la première couche de passivation (50) est disposée sur un côté de la première couche métallique ohmique (30) s'éloignant du substrat (10) et est disposée dans les régions lumineuses et la région non lumineuse, et la première couche de passivation (50) est pourvue d'un premier trou traversant (50A), au moins une partie de la première couche métallique ohmique (30) étant exposée depuis le premier trou traversant (50A) ;

le premier coussin (60) est disposé sur un côté de la première couche de passivation (50) s'éloignant du substrat (10), une projection du premier coussin (60) sur le substrat (10) ne chevauche pas une projection de la fenêtre d'émission (20a) d'un émetteur (20) respectif sur le substrat (10), et le premier coussin (60) est relié à la première couche métallique ohmique (30) à travers le premier trou traversant (50A) ;

la deuxième couche de passivation (70) est disposée sur une surface du premier coussin (60) s'éloignant du substrat (10) et recouvre les régions lumineuses ainsi que la région non lumineuse ;

la deuxième couche de passivation (70) et la première couche de passivation (50) sont pourvues d'un deuxième trou traversant (50B), dans lequel au moins une partie de la deuxième couche métallique ohmique (40) est exposée depuis le deuxième trou traversant (50B) ; et

le deuxième coussin (80) est disposé sur un côté de la deuxième couche de passivation (70) s'éloignant du substrat (10), une projection du deuxième coussin (80) sur le substrat (10) ne chevauche pas la projection de la fenêtre d'émission (20a) de l'émetteur respectif (20) sur le substrat (10), et le deuxième coussin (80) est relié à la deuxième couche métallique ohmique (40) à travers le deuxième trou traversant (50B).

2. VCSEL selon la revendication 1, dans lequel chacun des émetteurs (20) comprend en outre une première couche de contact ohmique (24) disposée dans une région lumineuse respective et dans la région non lumineuse, la première couche de contact ohmique (24) étant disposée dans le premier DBR (21), et le contact ohmique entre la première couche métallique ohmique (30) et le premier DBR (21) étant formé à travers la première couche de contact ohmique (24).

3. VCSEL selon la revendication 1, dans lequel la première couche métallique ohmique (30) est disposée dans une partie de la région non lumineuse parmi un $A_{ij}$-ème émetteur (20), un $A_{(i+1)(j)}$-ème émetteur (20), un $A_{(i)(j+1)}$-ème émetteur (20), et un $A_{(i+1)(j+1)}$-ème émetteur (20), où i est supérieur ou égal à 1 et inférieur ou égal à (m-1), et j est supérieur ou égal à 1 et inférieur ou égal à (n-1).

4. VCSEL selon la revendication 3, dans lequel une forme de la projection de la première couche métallique ohmique (30) sur le substrat (10) est centrosymétrique, et un centre de la forme de la projection de la première couche métallique ohmique (30) sur le substrat (10) coïncide avec un point d'intersection entre une troisième ligne de liaison et une quatrième ligne de liaison ;

dans lequel la troisième ligne de liaison est une ligne droite où se trouve une ligne de liaison reliant un centre du $A_{ij}$-ème émetteur (20) et un centre du $A_{(i+1)(j+1)}$-ème émetteur (20), et la quatrième ligne de liaison est une ligne droite où se trouve une ligne de liaison reliant un centre du $A_{(i+1)(j)}$-ème émetteur (20) et un centre du $A_{(i)(j+1)}$-ème émetteur (20).

5. VCSEL selon l'une quelconque des revendications 1 à 4, dans lequel la forme de la projection de la première couche métallique ohmique (30) sur le substrat (10) comprend un cercle ou un losange.

6. VCSEL selon la revendication 1, dans lequel le premier coussin (60) est disposé dans la région non lumineuse ; ou le premier coussin (60) est disposé dans la région non lumineuse et la région périphérique de l'émetteur (20) respectif.

7. VCSEL selon la revendication 1, dans lequel le deuxième coussin (80) est pourvu de m×n fenêtres d'émission de lumière (20a), et une projection de chacune des fenêtres d'émission de lumière (20a) sur le substrat (10) chevauche une projection d'une fenêtre d'émission (20a) respective sur le substrat (10).

8. VCSEL selon la revendication 1, dans lequel le premier coussin (60) comprend une partie de liaison principale et au moins une sous-partie de liaison en forme de bande dans une première direction reliée à la partie de liaison principale, la partie de liaison principale étant disposée sur un côté des émetteurs (20) disposés en réseau m×n, et chacune de l'au moins une sous-partie de liaison en forme de bande dans une première direction étant disposée entre deux rangées adjacentes des émetteurs (20).

9. VCSEL selon la revendication 8, dans lequel les émetteurs (20) disposés en réseau m×n sont divisés en Q régions de commande d'émission de lumière lumineuse, un nombre de premiers coussins (60) est K1, un nombre de deuxièmes coussins (80) est K2, Q est égal à un produit de K1 et K2, et Q est supérieur ou égal à 1 et inférieur ou égal à un produit de m et n.

10. VCSEL selon la revendication 8, dans lequel chacun des premiers coussins (60) comprend en outre au moins une sous-partie de liaison en forme de bande dans une deuxième direction, chacune de l'au moins une sous-partie de liaison en forme de bande dans une deuxième direction étant reliée à une respective de l'au moins une sous-partie de liaison en forme de bande dans une première direction ;
dans lequel, dans un cas où chacun des premiers coussins (60) comprend une pluralité de sous-parties de liaison en forme de bande dans une première direction et une pluralité de sous-parties de liaison en forme de bande dans une deuxième direction, deux sous-parties de liaison en forme de bande dans une deuxième direction adjacentes de la pluralité de sous-parties de liaison en forme de bande dans une deuxième direction et deux sous-parties de liaison en forme de bande dans une première direction adjacentes respectives de la pluralité de sous-parties de liaison en forme de bande dans une première direction formant une structure en forme de dièse, chacune de la pluralité de sous-parties de liaison en forme de bande dans une deuxième direction étant disposée entre deux colonnes adjacentes des émetteurs (20), et une projection de chacune des sous-parties de liaison en forme de bande dans une deuxième direction sur le substrat (10) ne chevauchant pas la projection de la fenêtre d'émission (20a) d'un émetteur (20) respectif sur le substrat (10).

11. VCSEL selon la revendication 1, dans lequel chacun des émetteurs (20) comprend en outre une couche d'oxydation de confinement (25), la couche d'oxydation de confinement (25) étant disposée dans le deuxième DBR (22) et pourvue d'une aperture d'oxydation (25A), et l'aperture d'oxydation (25A) étant une aperture optique définie pour l'un émetteur (20) respectif.

**FIG. 1**

**FIG. 2**

10A   10B   10A

21

10

21 22 23
20

**FIG. 3**

10A 10B 10A

24
21
10

21 22 23 30

20

**FIG. 4**

10A 10B 10A

24
21
10

21 22 23

20

**FIG. 5**

| 10A | 10B | 10A |

21 22 23    30

24

10

20

**FIG. 6**

10A 10B 10A

24

10

21 22 23

20

**FIG. 7**

**FIG. 8**

**FIG. 9**

**FIG. 10**

**FIG. 11**

**FIG. 12**

**FIG. 13**

FIG. 14

**FIG. 15**

**FIG. 16**

**FIG. 17**

**FIG. 18**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2021104867 A1
- US 2019076908 A1